# EUROPÄISCHE PATENTANMELDUNG

(11) **EP 4 391 086 A1**
(43) Veröffentlichungstag der Anmeldung: **26.06.2024**
(21) Anmeldenummer: 23219234.4
(22) Anmeldetag: 21.12.2023
(51) Int. Cl.: H01L 31/048

(54) **PHOTOVOLTAIK-PANEEL UND VERFAHREN ZUM HERSTELLEN EINES PHOTOVOLTAIK-PANEELS**

(30) Priorität: 23.12.2022 AT 510042022
(71) Anmelder: DAS ENERGY LIMITED, 3026 Limassol (CY)
(72) Erfinder: DRIES, Christian, 2522 Oberwaltersdorf (AT)
(74) Vertreter: Beer & Partner Patentanwälte KG

(57) **Zusammenfassung**

Ein Photovoltaik-Paneel umfasst eine an der dem Licht zugewandten Seite vorgesehene, flächige und transparente Frontabdeckung (1), eine an der dem Licht abgewandten Seite vorgesehene, Rückseitenabdeckung (6) und wenigstens eine Solarzelle (4) zwischen der Front- und Rückseitenabdeckung (1 bzw. 6). Vor der dem Licht zugewandten Seite der wenigstens einen Solarzelle (4) ist wenigstens ein stoßdämpfendes Einkapselungsmaterial (2), insbesondere ein Fasermaterial, das die wenigstens eine Solarzelle (4) bedeckt, vorgesehen und hinter der dem Licht abgewandten Seite der wenigstens einen Solarzelle (4) ist eine stabile Trägerschicht (5), insbesondere eine Glasplatte, vorgesehen.

## Beschreibung

Die Erfindung betrifft ein Photovoltaik-Paneel, umfassend eine an der dem Licht zugewandten Seite vorgesehene, flächige und transparente Frontabdeckung, eine an der dem Licht abgewandten Seite vorgesehene Rückseitenabdeckung und wenigstens eine Solarzelle zwischen Front- und Rückseitenabdeckung.

Die Erfindung betrifft zudem ein Verfahren zum Herstellen eines solchen Photovoltaik-Paneels.

Es ist bekannt, starre Photovoltaik-Paneele herzustellen, die auf der dem Licht zugewandten Vorderseite und auf der dem Licht abgewandten Rückseite eine Glasplatte aufweisen. Die Glasplatten müssen eine gewisse Dicke aufweisen, um Wetterbedingungen, insbesondere Hagel, standhalten zu können. Derartige Paneele sind in einem Rahmen eingefasst, der seitlich an den Rändern der Glasplatten angeordnet ist. Vorteilig bei solchen Paneelen ist, dass diese vergleichsweise stabil sind und einen gewissen Schutz vor mechanischer Einwirkung (z.B. Hagel) auf die Vorderseite bietet. Nachteilig bei solchen Paneelen ist es, dass diese vergleichsweise schwer sind, eine vergleichsweisen dicken Schichtaufbau haben und nicht flexibel sind. Wenn bei einem Hagelschaden die vordere Glasscheibe beschädigt wird und bricht, sinkt die Funktionalität des Paneels deutlich. Weiters müssen Vorkehrungen getroffen werden, dass der Schichtaufbau des Paneels belüftet wird, um eine Überhitzung zu vermeiden.

Es ist bekannt, leichtgewichtige Photovoltaik-Paneele herzustellen, deren mechanische Festigkeit durch Faserverbundwerkstoffe, die über die gesamte Paneelfläche vor und hinter den elektrisch leitenden Bauteilen vorgesehen sind, erreicht wird. Derartige Paneele benötigen keinen seitlichen Rahmen. Solche Paneele haben den Vorteil, dass diese nicht nur leicht, sondern auch flexibel sind, da auf Glasplatten im Schichtaufbau des Paneels verzichtet werden kann. Mechanische Einwirkungen auf die Vorderseite, z.B. durch Hagel, kann durch die Faserverbundwerkstoffe in einem gewissen Ausmaß ausgeglichen werden. Ein Nachteil besteht jedoch darin, dass sowohl der vor den Solarzellen als auch der nach den Solarzellen angeordnete Faserverbundwerkstoff bei mechanischer Einwirkung nachgibt, wodurch das Risiko besteht, dass die Solarzelle verformt wird und bricht.

Der Erfindung liegt die Aufgabe zu Grunde, die vorab beschriebenen Nachteile zu vermeiden. Insbesondere ist es Aufgabe der Erfindung, ein dünnes und leichtes Photovoltaik-Paneel mit verbessertem Schutz gegen mechanische Einwirkungen zur Verfügung zu stellen.

Gelöst wird diese Aufgabe erfindungsgemäß durch ein Photovoltaik-Paneel mit den Merkmalen des Anspruchs 1 und ein Verfahren mit den Merkmalen des Anspruches 12.

Bevorzugte Ausführungsformen der Erfindung sind Gegenstand der Unteransprüche.

Erfindungsgemäß ist vorgesehen, dass vor der dem Licht zugewandten Seite der wenigstens einen Solarzelle wenigstens ein stoßdämpfendes Einkapslungsmaterial, insbesondere ein Fasermaterial, das die wenigstens eine Solarzelle bedeckt, vorgesehen ist und hinter der dem Licht abgewandten Seite der wenigstens einen Solarzelle eine stabile Trägerschicht, insbesondere eine Glasplatte, vorgesehen ist.

Stoßdämpfend bedeutet im Sinne der Erfindung, dass das Einkapselungsmaterial unter Krafteinwirkung kinetische Energie durch ein Formveränderungsvermögen aufnehmen kann. Das Einkapselungsmaterial kann im Rahmen der Erfindung teilelastisch verformbar sein, so dass es sich unter mechanischer Einwirkung verformen kann aber nach Krafteinwirkung nicht wieder komplett in den ursprünglichen Ausgangszustand zurückkehren muss. Durch die teilelastische Verformbarkeit wird erreicht, dass die durch z.B. Hagel oder Sandstürme hervorgerufene Krafteinwirkung gedämpft wird.

Wenn im Weiteren beispielhaft auf eine Faserschicht auf ein Fasermaterial Bezug genommen wird, so ist es im Rahmen der Erfindung dennoch möglich, dass statt der Faserschicht bzw. des Fasermaterials auch ein anderes stoßdämpfendes, beispielsweise teilelastisch verformbares Einkapselungsmaterial gemeint sein kann. Im Rahmen der Erfindung ist ein Fasermaterial jedoch bevorzugt.

Durch die Anordnung der Faserschicht auf der dem Licht zugewandten Seite der Solarzellen kann erreicht werden, dass die Vorderseite des Solarpaneels eine glatte oder strukturierte Oberfläche aufweist, was je nach gewünschter Lichtbrechung vorteilhaft ausgewählt werden kann. Die Faserschicht hat zudem dämpfende Wirkung bei Hagelschlag. Das Vorsehen der stabilen Trägerschicht, insbesondere der Glasplatte, hat nicht nur den großen Vorteil, dass das Paneel eine bestimmte Festigkeit aufweist, was je nach Anwendungsgebiet besonders vorteilhaft sein kann - der überraschende Vorteil ist jedoch, dass das Anordnen der Trägerschicht auf der Rückseite der Solarzellen negative Auswirkungen von z.B. Hagel oder Sandstürmen auf der Vorderseite des Paneels ausgleicht. Das Verformen der Faserschicht auf der Vorderseite führt dann nicht mehr dazu, dass sich die Solarzellen hinter der Faserschicht verformen und brechen. Zudem kann das Paneel rahmenfrei und somit vergleichsweise leicht und dünn aber dennoch ausreichend steif sein. Dass kein Rahmen mehr in Kombination mit der Glasplatte verwendet werden muss, bietet vorteilhafte Montagemöglichkeiten.

Ein weiterer praktischer Vorteil besteht darin, dass eine Wärmeabstrahlung noch vorne erzielt wird, wobei keine Hinterlüftung notwendig ist.

Im Rahmen der Erfindung kann die stabile Trägerschicht, insbesondere die Glasplatte zwischen 1 bis 4 mm, insbesondere ca. 1,6 mm, dick sein.

In einer bevorzugten Ausführungsform ist vorgesehen, dass die Frontabdeckung durch das stoßdämpfende Einkapselungsmaterial oder durch eine transparente Folie, insbesondere eine ETFE-Folie, wobei das teilelastische Einkapselungsmaterial zwischen der transparenten Folie und der wenigstens einen Solarzelle angeordnet ist, gebildet ist.

Vorzugsweise ist auf der dem Licht zugewandten Seite und/oder auf der dem Licht abgewandten Seite der stabilen Trägerschicht und/oder zwischen der wenigstens einen Solarzelle und dem auf der dem Licht zugewandten Seite der Solarzelle angeordneten, stoßdämpfenden Einkapselungsmaterial eine thermoplastische oder duroplastische Folie, insbesondere eine Einkapselungsfolie, vorzugsweise eine EVA-Folie oder eine POE- oder PVB-Folie, vorgesehen.

Eine thermoplastische oder duroplastische Folie, insbesondere eine beim Herstellen von Photovoltaik-Paneelen verwendete Einkapselungsfolie, hat grundsätzlich die Funktion, ein faserverstärktes Verbundmaterial mit der wenigstens einen Solarzelle zu verkleben, wodurch positive mechanische Eigenschaften des Paneels hervorgerufen werden. Die Verwendung einer Einkapselungsfolie kann von der Oberflächenbeschaffenheit der Solarzelle abhängen, wobei die Oberflächenbeschaffenheit auf der Vorder- und Rückseite der Solarzelle unterschiedlich sein kann. Die Rückseite der Solarzelle kann derart z.B. mit einer Aluminiumbeschichtung beschichtet sein, dass ein dort optional vorgesehenes Faser- bzw. Verbundmaterial ausreichend gut an der Solarzelle haftet. An der Vorderseite der Solarzelle ist dies im Hinblick auf Transparenz nicht ohne Weiteres möglich, weshalb eine Einkapselungsfolie zwischen der Vorderseite der Solarzelle und dem Faser- bzw. Verbundmaterial vorteilhaft ist.

Eine Einkapselungsfolie an der dem Licht zugewandten Seite der stabilen Trägerschicht hat die Vorteile, dass die Solarzelle direkt über die Folie an der stabilen Trägerschicht anhaften kann. Ebenso hat eine an der stabilen Trägerschicht vorgesehene Einkapselungsfolie den Vorteil, dass ein angrenzendes Fasermaterial - welches vor der stabilen Trägerschicht für die beiderseitige Einbettung der Solarzelle vorteilhaft sein kann und hinter der stabilen Trägerschicht Schutz vor mechanischer Einwirkung auf die stabile Trägerschicht bietet (Glasbruch kann vermieden werden) - besser an der stabilen Trägerschicht anhaften kann.

Im Rahmen der Erfindung ist somit die vorteilhafte Möglichkeit geschaffen, dass zwischen der auf der dem Licht zugewandten Seite der stabilen Trägerschicht angeordneten Folie und der wenigstens einen Solarzelle ein weiteres stoßdämpfendes Einkapselungsmaterial, insbesondere ein Fasermaterial, das die wenigstens eine Solarzelle bedeckt, vorgesehen ist und dass zwischen dem weiterem Einkapselungsmaterial und der wenigstens einen Solarzelle eine weitere thermoplastische oder duroplastische Folie, insbesondere eine Einkapselungsfolie, vorzugsweise eine EVA-Folie oder eine POE- oder PVB-Folie, vorgesehen ist.

Ebenso ist die vorteilhafte Möglichkeit geschaffen, dass hinter der auf der dem Licht abgewandten Seite der stabilen Trägerschicht angeordneten Folie ein weiteres stoßdämpfendes Einkapselungsmaterial, insbesondere ein Fasermaterial, vorgesehen ist.

Im Rahmen der Erfindung kann vorgesehen sein, dass die Rückseitenbedeckung die stabile Trägerschicht oder eine Folie oder ein stoßdämpfendes Einkapselungsmaterial, insbesondere ein Fasermaterial, ist. Die Rückseitenabdeckung kann transparent oder blickdicht sein.

Im Rahmen der Erfindung ist es bevorzugt, wenn das Fasermaterial ein Verbundmaterial, insbesondere ein mit Fasern verstärkter Kunststoff, ist.

In einer praktisch besonders bevorzugten Ausführungsform ist das Verbundmaterial ein mit Fasern verstärkter Kunststoff auf Harzbasis, insbesondere auf Basis eines Acrylats enthaltend Epoxidgruppen, wobei das Acrylat enthaltend Epoxidgruppen ist. Insbesondere kann ein in EP 2 863 443 A1 offenbartes Verbundmaterial verwendet werden.

Im Rahmen der Erfindung ist es bevorzugt, wenn das Verbundmaterial vor und hinter der Solarzelle vorgesehen ist und die Solarzelle beidseitig einkapselt. Das Verbundmaterial vorne muss transparent sein. Das Verbundmaterial hinten hat nicht die Anforderungen an Transparenz wie vorne, sondern es kann blickdicht oder transparent sein und auf mechanische Eigenschaften des Paneels ausgelegt sein, z.B. durch einen höheren Anteil an Fasern oder durch unterschiedliche Flächengewichte der Fasern. Flächengewichte der Fasern können wie in EP 2 863 443 A1 offenbart gewählt werden.

Im Rahmen der Erfindung können die Fasern Glasfasern, Kunststofffasern, Carbonfasern, Natur- und/oder Steinfasern, beispielsweise Basaltfasern sein, die je nach ihren Eigenschaften und nach ihrer Anordnung im Paneel gewählt werden können. Eine Kombination aus zwei oder mehr als zwei Fasertypen ist möglich.

Wenn das Fasermaterial vor der wenigstens einen Solarzelle, d.h. an der dem Licht zugewandten Seite, vorgesehen ist, werden als Fasern Glasfasern bevorzugt, da diese nicht nur geeignete mechanische Eigenschaften haben, sondern auch die Transparenz eines herzustellenden Verbundmaterials nicht beeinträchtigen. Wenn das Fasermaterial hinter der wenigstens einen Solarzelle, d.h. an der dem Licht abgewandten Seite, vorgesehen ist, dann muss nicht auf Transparenz geachtet werden, sondern die Fasern können je nach den gewünschten sonstigen Eigenschaften gewählt werden, z.B. Basalt- und/oder Carbonfasern.

In einer vorteilhaften Ausführungsform der Erfindung ist vorgesehen, dass die Front- und/oder Rückseitenabdeckung sowie die stabile Trägerschicht jeweils einen umlaufenden Rand haben und in Richtung ihres Randes über das dazwischen angeordnete, stoßdämpfende Einkapselungsmaterial, insbesondere ein Fasermaterial, hinausragen, so dass das Einkapselungsmaterial derart von den Rändern der Front- und/oder Rückseitenabdeckung und der stabilen Trägerschicht beabstandet ist, dass ein Randbereich frei von Einkapselungsmaterial ist. Durch diese Kombination kann zuverlässig vermieden werden, dass Feuchtigkeit in den Schichtaufbau des Paneels eintritt, beispielsweise auf Grund der Kapillarwirkung von Fasern.

In einer vorteilhaften Weiterbildung der zuletzt genannten Ausführungsform kann vorgesehen sein, dass die Front- und/oder Rückseitenabdeckung in dem Randbereich, der frei von stoßdämpfendem Einkapselungsmaterial ist, mit der stabilen Trägerschicht verbunden, insbesondere verklebt, vorzugsweise über die auf der dem Licht zugewandten Seite der stabilen Trägerschicht angeordneten Folie verklebt, ist.

Zum Herstellen eines dünnen und leichten Photovoltaik-Paneels mit verbessertem Schutz gegen mechanische Einwirkungen ist erfindungsgemäß vorgesehen, dass wenigstens eine Solarzelle zwischen einem an der dem Licht zugewandten Seite der wenigstens einen Solarzelle vorgesehenen, stoßdämpfenden Einkapselungsmaterial, beispielsweise ein teilelastisches Einkapselungsmaterial, vorzugsweise ein Fasermaterial, und einer an der dem Licht abgewandten Seite der wenigstens einen Solarzelle vorgesehenen, stabilen Trägerschicht, beispielsweise eine Glasplatte, angeordnet wird.

Ein bevorzugter Verfahrensablauf kann wie folgt dargestellt werden
- Optionales Bereitstellen und gegebenenfalls Zuschneiden einer Folie als Frontabdeckung, insbesondere eine ETFE-Folie,
- Bereitstellen und gegebenenfalls Zuschneiden eines stoßdämpfenden Einkapselungsmaterials, insbesondere eines Fasermaterials, mit einer Fläche, die abhängig von der Fläche der wenigstens einen zu bedeckenden Solarzelle gewählt wird, wobei das Einkapslungsmaterial gegebenenfalls mit wenigstens einer weiteren Komponente zum Ausbilden eines Verbundmaterials in Verbindung gebracht wird,
- Anordnen des Einkapslungsmaterials direkt oder indirekt auf der Frontabdeckung,
- Anordnen einer thermoplastischen oder duroplastischen Folie auf dem Einkapselungsmaterial,
- Anordnen der wenigstens einen Solarzelle mit der dem Licht zugewandten Seite auf der thermoplastischen oder duroplastischen Folie,
- Anordnen einer thermoplastischen oder duroplastischen Folie auf der dem Licht abgewandten Seite der wenigstens einen Solarzelle,
- Optionales Anordnen eines weiteren Einkapselungsmaterials auf der dem Licht abgewandten Seite der wenigstens einen Solarzelle,
- Optionales Anordnen einer thermoplastischen oder duroplastischen Folie,
- Anordnen der dem Licht zugewandten Seite einer stabilen Trägerschicht auf der thermoplastischen oder duroplastischen Folie,
- Optionales Anordnen einer weiteren thermoplastischen oder duroplastischen Folie auf der dem Licht abgewandten Seite der stabilen Trägerschicht,
- Optionales Anordnen von weiterem Einkapselungsmaterial,
- Laminieren des gesamten Aufbaus.

Als Fasermaterial kann ein Fasergewebe verwendet werden und als weitere Komponente ein pulverförmiges Harz, insbesondere Acrylat enthaltend Epoxidgruppen, das auf das Fasergewebe aufgetragen wird.

Weitere Merkmale und Vorteile ergeben sich aus der nachfolgenden Beschreibung der Zeichnungen. Es zeigt:
- Fig. 1: einen schematischen Aufbau einer ersten Ausführungsform,
- Fig. 2: einen schematischen Aufbau einer zweiten Ausführungsform,
- Fig. 3: einen schematischen Aufbau einer dritten Ausführungsform und
- Fig. 4: einen schematischen Aufbau einer vierten Ausführungsform der Erfindung.

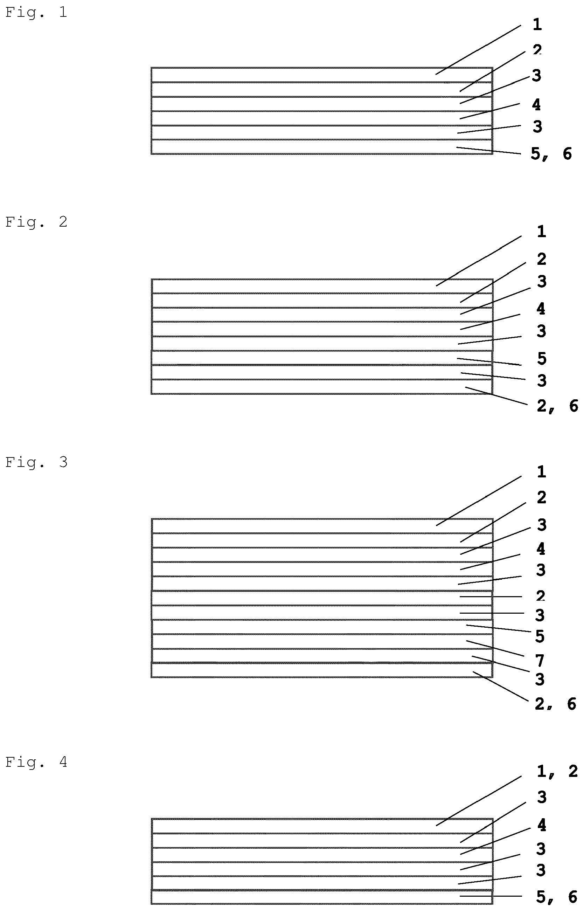

Fig. 1 zeigt einen Grundaufbau eines Photovoltaik-Paneels gemäß der Erfindung. Hinter einer ETFE-Folie als Frontabdeckung 1 ist ein Fasermaterial als stoßdämpfendes Einkapselungsmaterial 2 angeordnet. Das Einkapselungsmaterial 2 ist über eine EVA-Folie 3 mit Solarzellen 4 verbunden. Es versteht sich, dass die Solarzellen 4 mit elektrisch leitenden Elementen ausgestattet sind. Die Solarzellen 4 sind über eine weitere EVA-Folie 3 mit einer Glasplatte als stabile Trägerschicht 5 verbunden. Die Glaspatte bildet die Rückseitenabdeckung 6.

Fig. 2 entspricht im Wesentlichen der Fig. 1 mit dem Unterschied, dass hinter der Glasplatte eine weiteres Fasermaterial als teilelastisch verformbares Einkapselungsmaterial 2 vorgesehen ist, dass über eine weitere EVA-Folie 3 mit der Glasplatte verbunden ist.

Fig. 3 entspricht im Wesentlichen der Fig. 2 mit dem Unterschied, dass auch zwischen den Solarzellen 4 und der Glasplatte ein stoßdämpfendes Einkapselungsmaterial 2 mit einer entsprechend zusätzlichen EVA-Folie vorgesehen ist. Ebenso ist auf der Rückseite der Glasplatte noch eine Farbschicht 7 vorgesehen.

Bei den Fig. 1 bis 3 muss nicht eine Folie als Frontabdeckung (1) vorgesehen sein, sondern das Einkapselungsmaterial (2) kann die Frontabdeckung (1) bilden.

Fig. 4 zeigt den der Erfindung zu Grunde liegenden Grundaufbau mit einem stoßdämpfenden Einkapselungsmaterial (2) als Frontabdeckung (1), das über eine EVA-Folie (3) mit Solarzellen (4) verbunden ist. Die Solarzellen (4) sind wiederum über eine EVA-Folie (3) mit der stabilen Trägerschicht (5) verbunden.

## Patentansprüche

1. Photovoltaik-Paneel umfassend
- eine an der dem Licht zugewandten Seite vorgesehene, flächige und transparente Frontabdeckung (1),
- eine an der dem Licht abgewandten Seite vorgesehene Rückseitenabdeckung (6),
- und wenigstens eine Solarzelle (4) zwischen der Front- und Rückseitenabdeckung (1, 6),
**dadurch gekennzeichnet, dass**
- vor der dem Licht zugewandten Seite der wenigstens einen Solarzelle (4) wenigstens ein stoßdämpfendes Einkapselungsmaterial (2), insbesondere ein teilelastisch verformbares Einkapselungsmaterial, vorzugsweise ein Fasermaterial, das die wenigstens eine Solarzelle (4) bedeckt, vorgesehen ist und
- hinter der dem Licht abgewandten Seite der wenigstens einen Solarzelle (4) eine stabile Trägerschicht (5), insbesondere eine Glasplatte, vorgesehen ist.

2. Photovoltaik-Paneel nach Anspruch 1, **dadurch gekennzeichnet, dass** die Frontabdeckung (1) durch das stoßdämpfende Einkapselungsmaterial (2) oder durch eine transparente Folie, insbesondere eine ETFE-Folie, wobei das stoßdämpfende Einkapselungsmaterial (2) zwischen der transparenten Folie und der wenigstens einen Solarzelle (4) angeordnet ist, gebildet ist.

3. Photovoltaik-Paneel nach Anspruch 1 oder 2, **dadurch gekennzeichnet, dass** auf der dem Licht zugewandten Seite und/oder auf der dem Licht abgewandten Seite der stabilen Trägerschicht (5) und/oder zwischen der wenigstens einen Solarzelle (4) und dem auf der dem Licht zugewandten Seite der Solarzelle (4) angeordnetem, stoßdämpfende Einkapselungsmaterial eine thermoplastische oder duroplastische Folie, insbesondere eine Einkapselungsfolie, vorzugsweise eine EVA-Folie (3), vorgesehen ist.

4. Photovoltaik-Paneel nach Anspruch 3, **dadurch gekennzeichnet, dass** zwischen der auf der dem Licht zugewandten Seite der stabilen Trägerschicht (5) angeordneten Folie und der wenigstens einen Solarzelle (4) ein weiteres stoßdämpfendes Einkapselungsmaterial (2), insbesondere ein Fasermaterial, das die wenigstens eine Solarzelle (4) bedeckt, vorgesehen ist und dass zwischen dem weiterem stoßdämpfenden Einkapselungsmaterial (2) und der wenigstens einen Solarzelle (4) eine weitere thermoplastische oder duroplastische Folie, insbesondere eine Einkapselungsfolie, vorzugsweise eine EVA-Folie (3), vorgesehen ist.

5. Photovoltaik-Paneel nach Anspruch 3 oder 4, **dadurch gekennzeichnet, dass** hinter der auf der dem Licht abgewandten Seite der stabilen Trägerschicht (5) angeordneten Folie ein weiteres stoßdämpfendes Einkapselungsmaterial (2), insbesondere ein Fasermaterial, vorgesehen ist.

6. Photovoltaik-Paneel nach einem der Ansprüche 1 bis 5, **dadurch gekennzeichnet, dass** die Rückseitenbedeckung (6) die stabile Trägerschicht (5) oder eine Folie ist oder das Einkapselungsmaterial (2) nach Anspruch 5 ist.

7. Photovoltaik-Paneel nach einem der Ansprüche 1 bis 6, **dadurch gekennzeichnet, dass** das Fasermaterial ein Verbundmaterial, insbesondere ein mit Fasern verstärkter Kunststoff, ist.

8. Photovoltaik-Paneel nach Anspruch 7, **dadurch gekennzeichnet, dass** das Verbundmaterial ein mit Fasern verstärkter Kunststoff auf Harzbasis, insbesondere auf Basis eines Acrylats enthaltend Epoxidgruppen ist.

9. Photovoltaik-Paneel nach einem der Ansprüche 1 bis 8, **dadurch gekennzeichnet, dass** die Fasern Glasfasern, Kunststofffasern, Basaltfasern, Carbonfasern, Natur- und/oder Steinfasern sind.

10. Photovoltaik-Paneel nach einem der Ansprüche 1 bis 9, **dadurch gekennzeichnet, dass** die Front- und/oder Rückseitenabdeckung (1, 6) sowie die stabile Trägerschicht (5) jeweils einen umlaufenden Rand haben und in Richtung ihres Randes über das dazwischen angeordnete, stoßdämpfende Einkapselungsmaterial (2), insbesondere ein Fasermaterial, hinausragen, so dass das Einkapselungsmaterial derart von den Rändern der Front- und/oder Rückseitenabdeckung (1, 6) und der stabilen Trägerschicht (5) beabstandet ist, dass ein Randbereich frei von Einkapselungsmaterial (2) ist.

11. Photovoltaik-Paneel nach Anspruch 10, **dadurch gekennzeichnet, dass** die Front- und/oder Rückseitenabdeckung (1, 6) in dem Randbereich, der frei von stoßdämpfendem Einkapselungsmaterial (2) ist, mit der stabilen Trägerschicht (5) verbunden, insbesondere verklebt, vorzugsweise über die auf der dem Licht zugewandten Seite der stabilen Trägerschicht (5) angeordneten Folie verklebt, ist.

12. Verfahren zum Herstellen eines Photovoltaik-Paneels nach einem der Ansprüche 1 bis 11, **dadurch gekennzeichnet, dass** wenigstens eine Solarzelle (4) zwischen einem an der dem Licht zugewandten Seite der wenigstens einen Solarzelle (4) vorgesehenen, stoßdämpfenden Einkapselungsmaterial (2), beispielsweise ein teilelastisches Einkapselungsmaterial, vorzugsweise ein Fasermaterial, und einer an der dem Licht abgewandten Seite der wenigstens einen Solarzelle (4) vorgesehenen, stabilen Trägerschicht, beispielsweise eine Glasplatte, angeordnet wird.

13. Verfahren nach Anspruch 12, umfassend die folgenden Schritte:
- Optionales Bereitstellen und gegebenenfalls Zuschneiden einer Folie als Frontabdeckung (1), insbesondere eine ETFE-Folie,
- Bereitstellen und gegebenenfalls Zuschneiden eines stoßdämpfenden Einkapselungsmaterials (2), insbesondere eines Fasermaterials, mit einer Fläche, die abhängig von der Fläche der wenigstens einen zu bedeckenden Solarzelle (4) gewählt wird, wobei das Einkapslungsmaterial (2) gegebenenfalls mit wenigstens einer weiteren Komponente zum Ausbilden eines Verbundmaterials in Verbindung gebracht wird,
- Anordnen des Einkapslungsmaterials (2) direkt oder indirekt auf der Frontabdeckung,
- Anordnen einer thermoplastischen oder duroplastischen Folie auf dem Einkapselungsmaterial,
- Anordnen der wenigstens einen Solarzelle (4) mit der dem Licht zugewandten Seite auf der thermoplastischen oder duroplastischen Folie,
- Anordnen einer thermoplastischen oder duroplastischen Folie auf der dem Licht abgewandten Seite der wenigstens einen Solarzelle (4),
- Optionales Anordnen eines weiteren Einkapselungsmaterials (2) auf der dem Licht abgewandten Seite der wenigstens einen Solarzelle (4),
- Optionales Anordnen einer thermoplastischen oder duroplastischen Folie,
- Anordnen der dem Licht zugewandten Seite einer stabilen Trägerschicht (5) auf der thermoplastischen oder duroplastischen Folie,
- Optionales Anordnen einer weiteren thermoplastischen oder duroplastischen Folie auf der dem Licht abgewandten Seite der stabilen Trägerschicht (5),
- Optionales Anordnen von weiterem Einkapselungsmaterial (2),
- Laminieren des gesamten Aufbaus.

14. Verfahren nach Anspruch 12 oder 13, **dadurch gekennzeichnet, dass** als Fasermaterial ein Fasergewebe verwendet wird und als weitere Komponente ein pulverförmiges Harz, insbesondere Acrylat enthaltend Epoxidgruppen auf das Fasergewebe aufgetragen wird.
